# EUROPÄISCHE PATENTSCHRIFT

(11) **EP 3 370 072 B1**
(45) Veröffentlichungstag und Bekanntmachung des Hinweises auf die Patenterteilung: **07.04.2021**
(21) Anmeldenummer: 18154915.5
(22) Anmeldetag: 02.02.2018
(51) Int. Cl.: G01R 15/20, G01R 33/00

(54) **STROMMESSVORRICHTUNG, DEREN VERWENDUNG SOWIE SYSTEM MIT EINER STROMMESSVORRICHTUNG**
CURRENT MEASURING DEVICE, ITS USE, AND SYSTEM COMPRISING A CURRENT MEASURING DEVICE
DISPOSITIF DE MESURE DU COURANT, SON UTILISATION AINSI QUE SYSTÈME POURVU D'UN DISPOSITIF DE MESURE DU COURANT

(30) Priorität: 21.02.2017 DE 102017202744
(43) Veröffentlichungstag der Anmeldung: 05.09.2018
(73) Patentinhaber: Robert Bosch GmbH, 70442 Stuttgart (DE)
(72) Erfinder: Maerkle, Jens, 77815 Buehl (DE); Harsanyi, Balazs Bence, 71735 Eberdingen (DE)

(56) Entgegenhaltungen:
- EP-A1- 1 965 217
- EP-A1- 2 530 474
- EP-A1- 2 942 631
- DE-A1- 10 011 047
- US-A1- 2014 049 255
- US-A1- 2014 333 293
- US-A1- 2015 015 241
- US-A1- 2016 327 593

## Beschreibung

### Stand der Technik

Die Erfindung betrifft eine Strommessvorrichtung nach dem Oberbegriff des Anspruchs 1. Ferner betrifft die Erfindung die Verwendung sowie ein System umfassend einen Elektromotor sowie eine Antriebselektronik mit einer erfindungsgemäßen Strommessvorrichtung.

Aus dem Stand der Technik ist es bekannt, Strommessungen in Elektronikbaugruppen durch Leistungs-Shunts, Stromwandler oder andere magnetfeldbasierte Sensoren zu realisieren. Bei Strommessungen mittels Leistungs-Shunts wird stellvertretend für den Strom eine Spannung über einen im Lastkreis angeordneten Messwiderstand (Shunt) gemessen, die über Auswertemittel erfasst und weiterverarbeitet werden. Dazu muss der Messwiderstand im Leistungskreis in Reihe zu den stromführenden Bauteilen angeordnet werden, was neben der schaltungstechnischen Einplanung des Messwiderstandes auch zu quadratisch mit dem Strom ansteigenden Verlusten führt. Trotz dem Trend zu immer kleineren Messwiderständen durch neue, hochauflösendere Auswertemittel eignet sich diese Messmethode für Hochstromanwendungen aufgrund der Verluste nicht.

Für Hochstromanwendungen sind Strommessungen auf Basis von Stromwandlern für die Erfassung und Auswertung von magnetischen Feldlinien um einen stromführenden Leiter allgemein bekannt. Zur Erfassung und Homogenisierung der magnetischen Feldlinien wird der stromführende Leiter durch einen einen Luftspalt umfassenden Ringkern geführt, der aus einem weichmagnetischen Material gefertigt ist. Im Luftspalt ist zur Erfassung und Auswertung der sich im Ringkern ausbildenden und über den Luftspalt schließenden magnetischen Feldlinien ein magnetisch sensitives Sensormittel angeordnet, das in Abhängigkeit der erfassten Magnetfeldstärke eine Spannung an seinem Ausgang ausgibt, die proportional zum fließenden Strom ist. Derartige Sensormittel umfassende Sensorvorrichtungen werden von verschiedenen Anbietern zur Strommessung angeboten und müssen für einen Betrieb mit vorgeschriebenen Versorgungsspannungen durch zusätzliche Hilfselektronikbaugruppen angesteuert werden. Aufgrund von einem hohen Material- und Bauteilaufwand ist diese Art der Sensorvorrichtung mit hohen Kosten verbunden. Ferner ist nur eine erschwerte Integration der Sensorvorrichtungen in bestehende Anwendungen möglich, da das Durchführen der Leitungen durch den geschlossenen Stromsensor eine geeignete Kabelführung erfordert, die sich auch nur begrenzt in Fertigungsanlagen automatisieren lässt.

Aus der DE 10 2013 100 246 A1 ist eine Sensorvorrichtung bekannt. Die bekannte Strommessvorrichtung zeigt einen Stromwandler, der um eine zusätzliche Entstörfilteranordnung ergänzt ist, was sich im besonderen Maße für eine Strommessung in transformatorlosen Wechselrichtern eignet. Für die Stromerfassung ist ein Magnetfeldsensor vorgesehen, der in Wirkverbindung mit einem Ringkern steht. Für eine Strommessung muss der stromführende Leiter durch den Ringkern geführt werden, was eine automatische Fertigung erschwert und auch eine spezielle Kabelführung erfordert. Weitere Strommessvorrichtungen sind aus EP2942631, US2015/015241, US2014/049255, US2014/333293, EP1965217, US2016/327593 und EP2530474 bekannt.

### Offenbarung der Erfindung

Die Strommessvorrichtung mit den Merkmalen des Anspruchs 1 hat den Vorteil, dass sie kostengünstig herstellbar ist und eine einfache Integration auch in kompakten Hochstromanwendungen ermöglicht, insbesondere bei mobilen Anwendungen im Rahmen von einem Elektromotor umfassenden Fahrzeugen. Insbesondere erlaubt die Strommessvorrichtung eine Einplatinenlösung, so dass zusätzliche Hilfselektronik sowie für Verbindungsleitungen anfallende Kontaktklemmen eingespart werden können.

Die erfindungsgemäße Strommessvorrichtung zeichnet sich zunächst dadurch aus, dass die Strommessvorrichtung zum Erfassen und Auswerten eines Stroms in einem Leiterabschnitt ein Magnetflussleiterelement umfasst, das erfindungsgemäß den stromführenden Leiterabschnitt für eine Bündelung und Homogenisierung der sich aufgrund des Stromflusses im Leiterabschnitt um den Leiterabschnitt ausbildenden magnetischen Feldlinien abschnittsweise umschließt. Dabei ist es erfindungsgemäß vorgesehen, dass das Magnetflussleiterelement eine Öffnung aufweist, in die auf einem in die Öffnung hineinragenden Trägerelement ein Sensorelement angeordnet ist, wobei das Sensorelement zum Erfassen und Auswerten von Magnetfeldlinien ausgebildet ist, die durch das Magnetflussleiterelement vorteilhaft auf das Sensorelement geführt werden. Dabei ist es bevorzugt vorgesehen, dass die zu erfassenden Ströme durch einen Phasenstrom eines Elektromotors gebildet werden und in einem Bereich zwischen 50A bis 2000A, bevorzugt zwischen 100A bis 1000A, liegen. Für eine gute Messauflösung ist es erfindungsgemäß vorgesehen, dass der zum Führen der magnetischen Feldlinien bzw. zum Verstärken des magnetischen Feldes ausgebildete Magnetflussleiter aus einem Material besteht, das eine gute magnetische Leitfähigkeit aufweist, wobei die magnetische Permeabilität µ_{R} in einem Bereich von µ_{R} > 1000 liegt.

Vorteilhafte Weiterbildungen der erfindungsgemäßen Strommessvorrichtung sind in den Unteransprüchen aufgeführt.

Bei einer bevorzugten konstruktiven Ausgestaltungsform ist das Trägerelement in der Öffnung des Magnetflussleiterelements lösbar angeordnet. Durch die lösbare Anordnung ist auch eine nachträgliche Montage des Trägerelements gegeben und somit wird auch eine separate Bearbeitung des Trägerelements und des Magnetflussleiterelements möglich. Neben mehreren automatischen Bestückungsprozessen bietet dies auch die Möglichkeit, dass auf dem Trägerelement vorgesehene Funktionseinheiten, wie beispielsweise Elektronikbaugruppen, gesondert für Testzwecke in Betrieb genommen werden können. Alternativ ist aber auch eine gesonderte Durchführung von anderen Prüfverfahren und/oder mechanischen Belastungstests am Trägerelement möglich, bevor durch die finale Anordnung des Trägerelements in der Öffnung des Magnetflussleiterelements die erfindungsgemäße Strommessvorrichtung abschließend ausgebildet wird.

In einer bevorzugten konstruktiven Ausgestaltungsform weist das Magnetflussleiterelement eine U-förmige, V-förmige oder kreisförmige Querschnittsfläche auf, wobei im Inneren der Querschnittsfläche der den zu messenden Strom führende Leiterabschnitt angeordnet ist. Für eine nachträgliche Montage des Magnetflussleiters ist weiterbildend und vorteilhaft vorgesehen, dass die Öffnung des Magnetflussleiters größer als die Quererstreckung des Leiterabschnitts ist, damit der Magnetflussleiter auch nachträglich um den Leiterabschnitt angeordnet werden kann. Ferner ist vorteilhaft vorgesehen, dass der Magnetflussleiter aus einer Basis und zwei an den gegenüberliegenden Enden der Basis angeordneten Seitenschenkeln besteht, wobei in einer Messposition die offene Seite des Magnetflussleiterelements zum Trägerelement ausgerichtet ist.

Weiterbildend zeigt der Magnetflussleiter zwei Endabschnitte der Seitenschenkel, die gemeinsam die Öffnung mit einem Spalt ausbilden, wobei auch hier der Spalt derart ausgebildet ist, dass der Leiterabschnitt durch die Öffnung innerhalb der Querschnittsfläche des Magnetflussleiterelements angeordnet werden kann. Dabei ist bevorzugt, wenn der Magnetflussleiter aus einem Grundelement durch mechanisches Verformen gebildet wird, was eine besonders kostengünstige und einfache Fertigung ermöglicht.

Eine besonders bevorzugte Ausführungsform zeigt ein Trägerelement mit mindestens einer Aussparung, insbesondere ausgebildet in Form eines zusätzlichen Spaltes bzw. Schlitzes, in dem mindestens ein Endabschnitt des Seitenschenkels des Magnetflussleiters aufnehmbar ist. Bevorzugt ist eine Ausführungsform, die ein Trägermodul mit zwei Spalten bzw. Schlitzen aufweist, die jeweils ein Endabschnitt der Seitenschenkel des Magnetflussleiters aufnehmen können, um das auf dem Trägerelement angeordnete Sensorelement bevorzugt mittig zwischen den Endabschnitten des Magnetflussleiters anzuordnen. Die Schlitze sind dabei bevorzugt so ausgeführt, dass ein kontaktloses Einführen der Endabschnitte möglich ist. Alternativ kann aber auch eine Press- oder Schnappverbindung zwischen Trägerelement und Magnetflussleiterelement vorgesehen sein. Die Endabschnitte der Seitenschenkel sind zumindest abschnittsweise parallel zueinander ausgerichtet, wodurch sich zwischen den beiden Endabschnitten ein homogenes Magnetfeld aufbaut, in dem das Sensorelement auf dem Trägerelement angeordnet ist. Zusätzlich wird durch die parallele Ausbildung der Endabschnitte das Einfügen der Endabschnitte in die Schlitze optimiert, da diese keine variable Breite aufweisen müssen.

Für eine vorteilhafte Anbindung des Sensorelements in der Öffnung des Magnetflussleiters umfasst eine bevorzugte Weiterbildung des Trägerelements mindestens einen elektrischen Pfad, bevorzugt zur Kontaktierung des Sensorelements. Es kann auch vorgesehen sein, dass eine Vielzahl von elektrischen Pfaden auf dem Trägerelement vorgesehen sind, die gegenseitig isoliert sind und die Kontaktierung des Sensorelements mittels mehrerer Signale ermöglichen. Alternativ zu der oben erwähnten Ausführung kann das Trägerelement auch durch eine mehrlagige Leiterplatte gebildet sein, die nicht nur die Kontaktierung des mehrere Signale umfassenden Sensorelements ermöglicht, sondern auch das elektrische Anbinden des Leiterabschnitts, insbesondere in Form eines winklig, bevorzugt rechtwinklig, zum ersten Leiterabschnitt angeordneten zweiten Leiterabschnitts. Der zweite Leiterabschnitt kann insbesondere aus einer Leiterbahn der Leiterplatte gebildet sein und führt bevorzugt zu einem auf der Leiterplatte vorgesehenen Leistungsschalter und/oder zu anderen Baugruppen. Eine solche Ausführungsform bietet bei einer Serienfertigung Kostenersparnisse und ermöglicht neben einem kompakten Schaltungsaufbau auch eine hohe Automatisierung. Ferner ist ein niederinduktiver Schaltungsentwurf aufgrund eines kurzen, insbesondere durch die Strommessung in seiner Länge unbeeinflussten Leiterabschnitts möglich, weshalb die negativen Auswirkungen von Störgrößen, insbesondere der Einfluss von durch die Länge der Zuleitungen verursachten parasitären Induktivitäten, eingeschränkt wird.

Eine weitere Optimierung sieht in einer bevorzugten Ausführungsform vor, dass auch die Ansteuerelektronik zum Umformen des in dem Leiterabschnitt fließenden Stroms vorgesehenen Leistungsschalters auf dem gleichen Trägerelement wie das Sensorelement angeordnet ist und über im Trägerelement vorgesehene elektrische Pfade kontaktiert ist.

Ferner ist auch eine Optimierung möglich, bei der sämtliche für den Betrieb anfallende Elektronikbaugruppen auf dem Trägermodul angeordnet und elektrisch kontaktiert sind. Neben einem Reduzieren der Anzahl der Platinen auf bevorzugt eine Einzelplatine führt dies zu direkten und besonders kurzen Anbindungspfaden der Signale, die nicht nur störsicher ausfallen sondern aufgrund von wegfallenden Steckverbindungen auch Kostenvorteile ermöglichen.

Eine weitere Optimierung einer Ausführungsform zeigt ein Bauteil, das aus Kunststoff, insbesondere durch Spritzgusstechnik oder durch 3D-Drucktechnik gefertigt ist und mittels dem das Trägerelement, das Magnetflussleiterelement sowie der Leiterabschnitt in ihrer Lage zueinander positioniert werden können. Neben der stabilen Positionierung der Komponenten ermöglicht dies trotz zeitweise auftretenden Beschleunigungs- und Zentrifugalkräften einen sicheren Betrieb der erfindungsgemäßen Strommessvorrichtung, da Kurzschlüsse aufgrund von Relativbewegungen der Komponenten verhindert werden. Bevorzugt ist auch eine Ausgestaltung des Bauteils, bei der die Reihenfolge der Komponenten bei der Montage frei wählbar ist.

Besonders bevorzugt ist auch, wenn das Sensorelement Kontaktierungsmittel umfasst, die nicht nur ein mechanisches Anordnen des Sensorelements auf der Oberfläche des Trägerelements bzw. der Leiterplatte, sondern auch ein elektrisches Kontaktieren der Anschlüsse ermöglichen. Dabei ist besonders bevorzugt, wenn das Sensorelement ein SMD-konformes Bauteilgehäuse aufweist, das bevorzugt auf einer Oberfläche des als Leiterplatte ausgebildeten Trägerelements auf vorgesehenen Kontaktierungsstellen, bevorzugt einem Footprint, aufgebracht werden kann.

In der beanspruchten Ausführungsform der Strommessvorrichtung umfasst das Sensorelement Magnetfelderfassungsmittel, die derart ausgebildet sind, dass nur parallel zum Trägerelement verlaufende Magnetfeldlinien erfassbar sind. Dabei ist vorteilhaft vorgesehen, dass die Magnetfeldlinien durch den Magnetflussleiter auf das in der Öffnung angeordnete Sensorelement ausgerichtet werden, wobei dies bevorzugt parallel zur Oberfläche des Trägerelements erfolgt. Weiterbildend und vorteilhaft umfasst das Sensorelement dabei nicht nur Magnetfelderfassungsmittel, sondern auch Magnetfeldauswertemittel und/oder Energieversorgungsmittel, wobei die Energieversorgungsmittel die aus elektrischen Baugruppen gebildeten Magnetfelderfassungsmittel und/oder Magnetfeldauswertemittel mit Versorgungsspannungen versorgen. Dies ermöglicht den vorteilhaften Einsatz von allgemein bekannten Sensorelementen, die bevorzugt auf einem magnetoresistiven Effekt oder Hall Effekt beruhen und zusätzlich vorteilhaft zu geringen Materialkosten der erfindungsgemäßen Strommessvorrichtung führen.

Weiterhin erfasst die Erfindung die Verwendung einer erfindungsgemäßen Strommessvorrichtung in einem einen Elektromotor umfassenden Fahrzeug.

Auch umfasst die Erfindung ein System mit einer erfindungsgemäßen Strommessvorrichtung, die in einer Antriebselektronik für einen Elektromotor in einem Fahrzeug eingesetzt wird.

Weitere Vorteile, Merkmale und Einzelheiten der Erfindung ergeben sich aus der nachfolgenden Beschreibung bevorzugter Ausführungsbeispiele sowie anhand der Zeichnung.

Diese zeigt in:
- Fig. 1: eine bevorzugte Ausführungsform der erfindungsgemäßen Strommessvorrichtung in einer vereinfachten perspektivischen Darstellung,
- Fig. 2a bis 2c: bevorzugte Ausführungsformen des erfindungsgemäß vorgesehenen Magnetflussleiterelements in einer Schnittdarstellung und
- Fig. 3: eine grafische Darstellung der sich um einen Leiterabschnitt ausbildenden Magnetfeldlinien.

In den Figuren sind gleiche Elemente und Elemente mit der gleichen Funktion mit den gleichen Bezugszeichen gekennzeichnet.

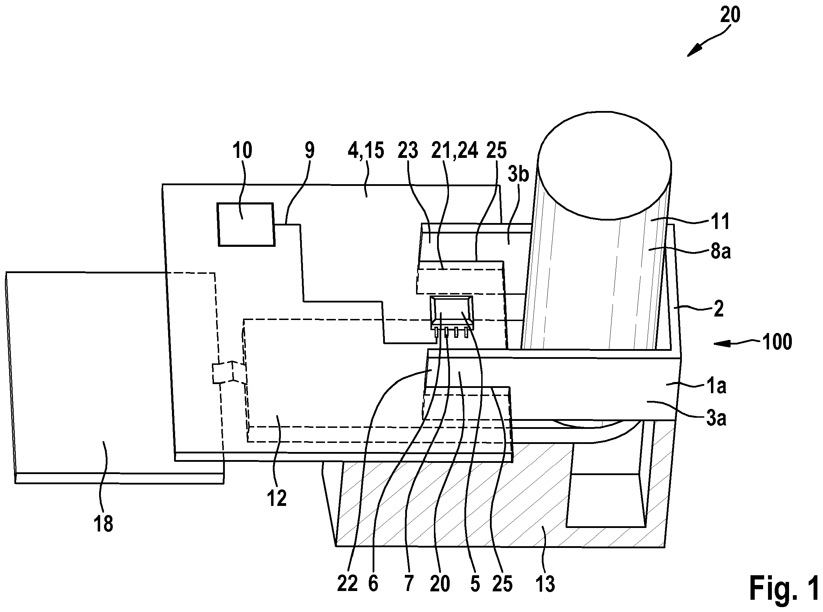

In Fig. 1 ist eine Anordnung 20 zum Erfassen eines Stromes in einem Leiterabschnitt 8a; 8b mit einer Strommessvorrichtung 100 gezeigt. Die Anordnung 20 zeigt ein einen U-förmigen Querschnitt aufweisendes Magnetflussleiterelement 1a, das aus einem magnetflussleitenden Material besteht. Die U-förmige Querschnittsfläche wird aus einem Basisschenkel 2 und zwei Seitenschenkeln 3a, 3b gebildet, die an den gegenüberliegenden Enden des Basiselements 2 angeordnet sind und sich zueinander parallel erstrecken. Die offene Seite des Magnetflussleiterelements 1a ist in Richtung einer als Trägerelement 15 wirkenden Leiterplatte 4 ausgerichtet, die erfindungsgemäß in die Öffnung 21 zwischen den beiden Seitenschenkeln 3a, 3b hineinragt, der als Spalt 24 ausgebildet ist. Zum Aufnehmen der beiden Endabschnitte 22, 23 der Seitenschenkel 3a, 3b sind in dem als Leiterplatte 4 ausgebildeten Trägerelement 15 zwei Spalte bzw. Schlitze 25 vorgesehen. Auf der Leiterplatte 4 in der Mitte zwischen den beiden Seitenschenkeln 3a, 3b ist ein als Hall-Sensor ausgebildetes Sensorelement 5 angeordnet, das über am Gehäuse 6 des Sensorelements 5 vorgesehene Kontaktierungsmittel 7 auf der Oberfläche der Leiterplatte 4 elektrisch kontaktiert und mechanisch fixiert ist. Die geschlossene Seite des Magnetflussleiterelements 1a umgibt einen einen Strom führenden und einen runden Querschnitt aufweisenden Leiterabschnitt 8a, der einen ersten Teilabschnitt 11 aufweist, der vom Magnetflussleiter 1a umgeben ist und an dem ein zweiter Teilabschnitt 12 rechtwinklig und parallel zum Trägermodul 15 bzw. der Leiterplatte 4 angeordnet ist. Der zweite Teilabschnitt 12 führt den Strom zu einem stark vereinfacht dargestellten Leistungsschalter 18, der mit der Leiterplatte 4 elektrisch kontaktiert ist. Durch ein Kunststoffbauteil 13 erfolgt eine relative Positionierung der Leiterplatte 4, des Magnetflussleiterelements 1a sowie des aus dem ersten Teilabschnitt 11 und dem zweiten Teilabschnitt 12 gebildeten Leiterabschnitts 8a zueinander.

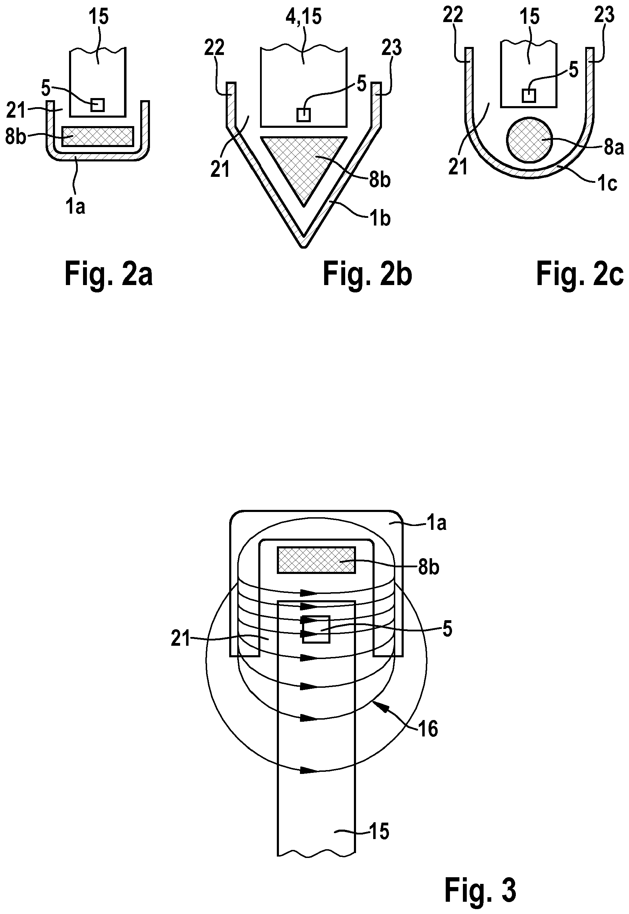

Im Betrieb der Anordnung 20 fließt im runden Leiterabschnitt 8a ein Strom, was zur Folge hat, dass sich um den Leiterabschnitt 8a magnetische Feldlinien 16 ausbilden (Fig. 3). Da das Magnetflussleiterelement 1a aus einem eine hohe magnetische Permeabilität aufweisenden Material besteht, verlaufen die ausgebildeten Magnetfeldlinien 16 vermehrt im U-förmigen Magnetflussleiter 1a und schließen sich in einem Bereich, in dem auf der Leiterplatte 4 das zur Erfassung der Magnetfeldlinien 16 ausgebildete Sensorelement 5 angeordnet ist. Da das Sensorelement 5 Magnetflusserfassungsmittel umfasst, kann in Abhängigkeit der Stärke der Magnetfeldlinien 16 eine Sensorausgangsspannung erzeugt werden, die über eine in der Leiterplatte 4 vorgesehene Leiterbahn 9 an eine bevorzugt zentrale und insbesondere digitale Recheneinheit 10 übermittelt wird. Alternativ kann das Sensorsignal jedoch auch mittels Analogtechnik weiterverarbeitet werden, insbesondere zum Erzeugen eines Ansteuersignals für einen oder mehrere Leistungsschalter 18. Da die Stärke des Magnetfelds von dem im Leiterabschnitt 8a fließenden Strom abhängt, besteht ein Zusammenhang zwischen der Sensorausgangsspannung und der im Leiterabschnitt 8a fließenden Stromstärke.

In den Fig. 2a bis 2c sind bevorzugte Ausführungsformen des Magnetflussleiterelements 1a, 1b, 1c dargestellt. Die Fig. 2a zeigt die Querschnittsfläche des Magnetflussleiterelements 1a, wie schon in Fig. 1, eine U-förmige Grundform, wobei in der Öffnung 21 des Magnetflussleiterelements 1a das Sensorelement 5 auf einem Trägerelement 15 angeordnet ist. Im Innern des Magnetflussleiterelements 1a ist der stromführende einen rechteckigen Querschnitt aufweisende Leiterabschnitt 8b angeordnet.

In der Fig. 2b zeigt die Querschnittsfläche des Magnetflussleiterelements 1b eine V-förmige Grundform bei der der erste und der zweite Endabschnitt 22, 23 parallel zueinander ausgerichtet sind und gemeinsam eine Öffnung 21 bilden, in die das Trägerelement 15, das das Sensorelement 5 trägt, hineinragt. Das Trägerelement 15 umgibt einen dreieckigen Leiterabschnitt 8b.

### Ferner zeigt die Fig. 2c eine kreisförmige Grundform des

Magnetflussleiterelements 1c, wobei wiederum in der Öffnung 21 des Magnetflussleiterelements 1c ein Sensorelement 5 auf einem Trägerelement 15 angeordnet ist. Auch hier wird die Öffnung 21 des Trägerelements 15 von zwei parallel zueinander angeordneten Endabschnitten 22, 23 gebildet. Ferner ist in der Fig. 2c die Öffnung 21 so groß, dass der Leiterabschnitt 8a durch die Öffnung 21 in das Innere des runden Magnetflussleiterelements 1c eingeführt werden kann.

Die Fig. 3 zeigt schematisch die sich um den stromführenden eckigen Leiterabschnitt 8b ausbildenden Magnetfeldlinien 16, die durch das Magnetflussleiterelement 1a geführt und somit homogen über dem in der Öffnung 21 auf einem Trägerelement 15 angeordneten Sensorelement 5 ausgerichtet werden. Da das Magnetflussleiterelement 1a aus einem gut magnetisch leitenden Material gefertigt ist, findet durch die Anordnung des Magnetflussleiterelements 1a um den Leiterabschnitt 8b eine Bündelung und Ausrichtung der Magnetflusslinien 16 statt, wodurch in der Öffnung 21 im Bereich des auf dem Trägerelement 15 angeordneten Sensorelements 5 ein homogener Feldverlauf erzielt wird, was sich durch einen parallelen Magnetfeldlinienverlauf 16 zeigt.

Die soweit beschriebene Anordnung 20 kann in vielfältiger Art und Weise abgewandelt bzw. modifiziert werden, ohne von der beanspruchten Erfindung abzuweichen. Insbesondere wird darauf hingewiesen, dass die Querschnittsfläche des Magnetflussleiterelements 1a; 1b; 1c auch andere Konturen aufweisen kann. Alternativ ist eine Verwendung der erfindungsgemäßen Strommessvorrichtung 100 auch in stationären Anwendungen möglich.

## Patentansprüche

1. Strommessvorrichtung (100) zum Erfassen eines elektrischen Stroms in einem, insbesondere einen Phasenstrom eines Elektromotors führenden Leiterabschnitt (8a; 8b) mittels eines zum Erfassen von Magnetfeldlinien (16) ausgebildeten Sensorelements (5), das in einer Öffnung (21) eines zum Führen der durch einen Stromfluss durch den Leiterabschnitt (8a; 8b) verursachten Magnetfeldlinien (16) ausgebildeten Magnetflussleiterelements (1a; 1b; 1c) angeordnet ist,
wobei
das Sensorelement (5) auf einem in die Öffnung (21) des Magnetflussleiterelements (1a; 1b; 1c) hineinragenden Trägerelement (15) angeordnet ist,
**dadurch gekennzeichnet, dass**
der Leiterabschnitt (8a, 8b) einen ersten Teilabschnitt (11) aufweist, der rechtwinklig zum Trägerelement (15) angeordnet ist, und in dem der Stromfluss rechtwinklig zum Trägerelement verläuft, und das Sensorelement (5)
Magnetfelderfassungsmittel aufweist, die derart ausgebildet sind, dass nur parallel zum Trägerelement (15) verlaufende Magnetfeldlinien (16) erfassbar sind.

2. Strommessvorrichtung nach Anspruch 1,
**dadurch gekennzeichnet,**
**dass** das Trägerelement (15) lösbar in der Öffnung (21) des Magnetflussleiterelements (1a; 1b; 1c) angeordnet ist.

3. Strommessvorrichtung nach Anspruch 1 oder 2,
**dadurch gekennzeichnet,**
**dass** das Magnetflussleiterelement (1a; 1b; 1c) eine U-förmige, V-förmige oder kreisförmige Querschnittsfläche aufweist wobei innerhalb der Querschnittsfläche der Leiterabschnitt (8a; 8b) angeordnet ist.

4. Strommessvorrichtung nach Anspruch 1 bis 3,
**dadurch gekennzeichnet,**
**dass** das Magnetflussleiterelement (1a; 1b; 1c) zwei Endabschnitte (22, 23) aufweist, die eine Öffnung (21) mit einem Spalt (24) ausbilden.

5. Strommessvorrichtung nach Ansprüche 4,
**dadurch gekennzeichnet,**
**dass** das Trägerelement (15) wenigstens eine Aussparung, insbesondere in der Form eines zusätzlichen Spaltes (25) aufweist, in die mindestens einer der Endabschnitte (22, 23) aufnehmbar ist.

6. Strommessvorrichtung nach einem der Ansprüche 1 bis 5,
**dadurch gekennzeichnet,**
**dass** das Trägerelement (15) wenigstens einen elektrisch leitenden Pfad aufweist oder dass das Trägerelement (15) als mehrlagige Leiterplatte (4) ausgebildet ist.

7. Strommessvorrichtung nach Anspruch 6,
**dadurch gekennzeichnet,**
**dass** der Leiterabschnitt (8a; 8b) elektrisch leitend mit einer Leiterbahn (9) der Leiterplatte (4) und/oder mit mindestens einem auf der Leiterplatte (4) angeordneten Leistungsschalter (18) verbunden ist.

8. Strommessvorrichtung nach einem der Ansprüche 1 bis 7,
**dadurch gekennzeichnet,**
**dass** die Leiterplatte (4), das Magnetflussleiterelement (1a; 1b) sowie der Leiterabschnitt (8a; 8b) mittels eines Bauteils (13) in ihrer Lage zueinander positioniert sind.

9. Strommessvorrichtung nach einem der Ansprüche 1 bis 8,
**dadurch gekennzeichnet,**
**dass** das Sensorelement (5) zum elektrischen Kontaktieren und mechanischen Fixieren des Sensorelements (5) mit der Oberfläche des Trägerelements (15) in einem Kontaktierungsmittel (7) aufweisenden Gehäuseelement (6) angeordnet ist.

10. Verwendung einer Strommessvorrichtung (100), die nach einem der Ansprüche 1 bis 9 ausgebildet ist, in einem einen Elektromotor aufweisenden Fahrzeug.

11. System, umfassend mindestens eine Strommessvorrichtung (100) nach einem der Ansprüche 1 bis 9, und ein einen Elektromotor sowie ein eine Antriebselektronik aufweisendes Fahrzeug, wobei die Strommessvorrichtung (100) zur Erfassung eines Stroms in der Antriebselektronik ausgebildet ist.

## Claims

1. Current-measuring device (100) for measuring an electric current in a conductor section (8a; 8b) which conducts, in particular, a phase current of an electric motor, by means of a sensor element (5) which is designed to detect magnetic field lines (16) and is arranged in an opening (21) in a magnetic flux-conductor element (1a; 1b; 1c) which is designed to guide magnetic field lines (16) caused by a flow of current through the conductor section (8a; 8b),
wherein
the sensor element (5) is arranged on a carrier element (15) which projects into the opening (21) in the magnetic flux-conductor element (1a; 1b; 1c),
**characterized in that**
the conductor section (8a, 8b) has a first partial section (11) which is arranged at a right angle to the carrier element (15) and in which the flow of current runs at a right angle to the carrier element, and the sensor element (5) has magnetic field-detection means which are designed in such a way that only magnetic field lines (16) running parallel to the carrier element (15) can be detected.

2. Current-measuring device according to Claim 1, **characterized**
**in that** the carrier element (15) is detachably arranged in the opening (21) in the magnetic flux-conductor element (1a; 1b; 1c).

3. Current-measuring device according to Claim 1 or 2,
**characterized**
**in that** the magnetic flux-conductor element (1a; 1b; 1c) has a U-shaped, V-shaped or circular cross-sectional area, wherein the conductor section (8a; 8b) is arranged within the cross-sectional area.

4. Current-measuring device according to Claims 1 to 3,
**characterized**
**in that** the magnetic flux-conductor element (1a; 1b; 1c) has two end sections (22, 23) which form an opening (21) with a gap (24).

5. Current-measuring device according to Claim 4, **characterized**
**in that** the carrier element (15) has at least one cutout, in particular in the form of an additional gap (25) into which at least one of the end sections (22, 23) can be received.

6. Current-measuring device according to one of Claims 1 to 5,
**characterized**
**in that** the carrier element (15) has at least one electrically conductive path, or in that the carrier element (15) is embodied as a multi-layer circuit board (4).

7. Current-measuring device according to Claim 6, **characterized**
**in that** the conductor section (8a; 8b) is connected in an electrically conductive fashion to a conductor track (9) of the circuit board (4) and/or to at least one power switch (18) which is arranged on the circuit board (4).

8. Current-measuring device according to one of Claims 1 to 7,
**characterized**
**in that** the circuit board (4), the magnetic flux-conductor element (1a; 1b) and the conductor section (8a; 8b) are positioned with respect to one another by means of a component (13).

9. Current-measuring device according to one of Claims 1 to 8,
**characterized**
**in that** in order to make electrical contact of the sensor element (5) with the surface of the carrier element (15) and to secure it mechanically thereto, the sensor element (5) is arranged in a housing element (6) having contact-forming means (7).

10. Use of a current-measuring device (100) which is embodied according to one of Claims 1 to 9, in a vehicle having an electric motor.

11. System comprising at least one current-measuring device (100) according to one of Claims 1 to 9, and a vehicle having an electric motor and drive electronics, wherein the current-measuring device (100) is designed to detect a current in the drive electronics.

## Revendications

1. Dispositif de mesure de courant (100) permettant de détecter un courant électrique dans une partie de conducteur (8a ; 8b), en particulier parcourue par un courant de phase d'un moteur électrique, au moyen d'un élément capteur (5) réalisé pour détecter des lignes de champ magnétique et disposé dans une ouverture (21) d'un élément conducteur de flux magnétique (1a ; 1b ; 1c) réalisé pour guider les lignes de champ magnétique (16) provoquées par une circulation de courant par la partie de conducteur (8a ; 8b),
dans lequel l'élément capteur (5) est disposé sur un élément porteur (15) faisant saillie dans l'ouverture (21) de l'élément conducteur de flux magnétique (1a ; 1b ; 1c),
**caractérisé en ce que** la partie de conducteur (8a, 8b) présente une première partie partielle (11) qui est disposée perpendiculairement à l'élément porteur (15), et dans laquelle la circulation de courant s'étend perpendiculairement à l'élément porteur, et **en ce que** l'élément capteur (5) présente des moyens de détection de champ magnétique qui sont réalisés de telle sorte que seules des lignes de champ magnétique (16) s'étendant en parallèle à l'élément porteur (15) peuvent être détectées.

2. Dispositif de mesure de courant selon la revendication 1, **caractérisé en ce que** l'élément porteur (15) est disposé de manière amovible dans l'ouverture (21) de l'élément conducteur de flux magnétique (1a ; 1b ; 1c).

3. Dispositif de mesure de courant selon la revendication 1 ou 2, **caractérisé en ce que** l'élément conducteur de flux magnétique (1a ; 1b ; 1c) présente une superficie de la section en forme de U, en forme de V ou circulaire, la partie de conducteur (8a ; 8b) étant disposée à l'intérieur de la superficie de la section.

4. Dispositif de mesure de courant selon la revendication 1 à 3, **caractérisé en ce que** l'élément conducteur de flux magnétique (1a ; 1b ; 1c) présente deux parties d'extrémité (22, 23) qui réalisent une ouverture (21) dotée d'une fente (24).

5. Dispositif de mesure de courant selon la revendication 4, **caractérisé en ce que** l'élément porteur (15) présente au moins un dégagement, en particulier sous la forme d'une fente supplémentaire (25), dans lequel au moins l'une des parties d'extrémité (22, 23) peut être reçue.

6. Dispositif de mesure de courant selon l'une quelconque des revendications 1 à 5, caractérisé en ce l'élément porteur (15) présente au moins un chemin électriquement conducteur, ou en ce que l'élément porteur (15) est réalisé sous la forme d'une carte de circuit multicouche (4).

7. Dispositif de mesure de courant selon la revendication 6, **caractérisé en ce que** la partie de conducteur (8a ; 8b) est reliée de manière électriquement conductrice à une piste conductive (9) de la carte de circuit (4) et/ou à au moins un commutateur de puissance (18) disposé sur la carte de circuit (4).

8. Dispositif de mesure de courant selon l'une quelconque des revendications 1 à 7, **caractérisé en ce que** la carte de circuit (4), l'élément conducteur de flux magnétique (1a ; 1b) ainsi que la partie de conducteur (8a ; 8b) sont positionnés dans leur positions mutuelles au moyen d'un composant (13).

9. Dispositif de mesure de courant selon l'une quelconque des revendications 1 à 8, **caractérisé en ce que** l'élément capteur (5) est disposé pour établir un contact électrique avec, et fixer mécaniquement l'élément capteur (5) à la surface de l'élément porteur (15) dans un élément formant boîtier (6) présentant des moyens d'établissement de contact (7).

10. Utilisation d'un dispositif de mesure de courant (100) réalisé selon l'une quelconque des revendications 1 à 9 dans un véhicule présentant un moteur électrique.

11. Système, comprenant au moins un dispositif de mesure de courant (100) selon l'une quelconque des revendications 1 à 9 et un véhicule présentant un moteur électrique ainsi qu'une électronique d'entraînement, le dispositif de mesure de courant (100) étant réalisé pour détecter un courant dans l'électronique d'entraînement.
